Europäisches Patentamt

European Patent Office

Office européen des brevets

(19)

(11) Publication number: **0 020 084**
**B1**

# EUROPEAN PATENT SPECIFICATION

(45) Date of publication of patent specification: **28.09.83**

(51) Int. Cl.³: **H 05 K 7/20**

(21) Application number: **80301681.5**

(22) Date of filing: **21.05.80**

(54) **An electronics rack cooled by natural air convection.**

(30) Priority: **28.05.79 JP 64959/79**

(43) Date of publication of application:
**10.12.80 Bulletin 80/25**

(45) Publication of the grant of the patent:
**28.09.83 Bulletin 83/39**

(84) Designated Contracting States:
**DE FR GB IT SE**

(56) References cited:
**DE - A - 2 755 811**
**DE - B - 1 103 433**
**US - A - 3 730 264**
**US - A - 3 874 444**

(73) Proprietor: **FUJITSU LIMITED**
**1015, Kamikodanaka Nakahara-ku**
**Kawasaki-shi Kanagawa 211 (JP)**

(72) Inventor: **Matsui, Kiyoshi**
**100-A404, Idasanmai-cho**
**Nakahara-ku Kawasaki-shi, Kanagawa 211 (JP)**
Inventor: **Arai, Katsuyuki**
**928, Noborito, Tama-ku**
**Kawasaki-shi Kanagawa 214 (JP)**
Inventor: **Shinbashi, Sueo**
**19, Shimonamiki, Kawasaki-ku**
**Kawasaki-shi Kanagawa 210 (JP)**

(74) Representative: **Allman, Peter John et al,**
**Marks and Clerk Scottish Life House Bridge Street**
**Manchester M3 3DP (GB)**

Courier Press, Leamington Spa, England

An electronics rack cooled by natural air convection

The present invention relates to a rack for housing a number of printed boards, and more particularly it relates to an improvement of a natural air convection cooled rack for vertically disposed printed boards.

In for example a communication system, a number of printed boards on which electric or electronic elements are mounted are housed within a rack. A natural air convection cooled rack is known in which many interspaced printed boards are disposed vertically so that air naturally passes between the printed boards in order to cool them. Such a rack comprises a plurality of stacked cases each housing a number of vertically disposed printed boards, apertures being provided in the top and bottom of each case to allow cooling air to flow therethrough. In order to effectively occupy the floor space, it is usual to arrange two racks so that the back of one rack faces the back of the other rack. Such an arrangement is called a back-to-back arrangement.

In order to encourage the flow of cooling air over the circuit boards in back-to-back racking arrangements, it is known from U.S. Patent Specification No. 3 730 264 to form interspaces between vertically adjacent cases so that air can flow into and out of the cases from in front of the racks. To reduce the degree to which heated air from a lower case mixes in the interspace with cool air entering an upper case, a separator or deflector is used to deflect heated air rising from the lower case array from the air inlet to the upper case. In U.S. Patent Specification No. 3 730 264 the described deflector is in the form of a plate which when viewed from in front of the interspace is V-shaped, heated air rising into the interspace being deflected forwards and sideways and cool air entering the interspace over the front edge of the deflector. This reduces the mixing of the heated and cool air flows, particularly in the central section of the interspace, but some mixing still occurs.

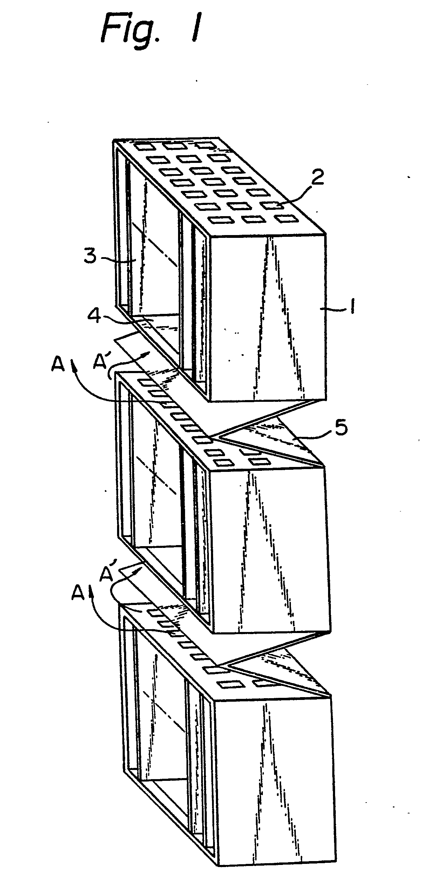

In a more simple prior art arrangement described in detail below with reference to Fig. 1, a deflector is located in an interspace which simply deflects the heated air flow forwards. With this arrangement however a considerable proportion of the heated air from a lower case is drawn back into the upper case.

It is an object of the present invention to avoid the degradation of the cooling effect in an upper case of an electronics rack cooled by natural air convection due to heated air rising from a lower case.

According to the present invention there is provided an electronics rack cooled by natural air convection, comprising at least two cases stacked one above the other so as to define an interspace therebetween, at least one draught aperture in the top of the lower case opening into the interspace, at least one draught aperture in the bottom of the upper case opening into the interspace, and means for channelling air from the or each aperture in the lower case to at least one exhaust opening and for channelling air to the or each aperture in the upper case from at least one supply opening, the supply and exhaust openings being located in different regions of the front of the interspace, characterised in that the air channelling means comprises a baffle partitioning the interspace into upper and lower compartments communicating respectively with the apertures of the upper and lower cases, one of the compartments being located so as to communicate directly with the front of the interspace, and at least one passage extending from an opening in the baffle through the said one compartment so as to connect the other compartment to the front of the interspace, the baffle and said at least one passage being arranged such that the upper compartment communicates only with one or more supply openings located in a lower region at the front of the interspace and the lower compartment communicates only with one or more exhaust openings located above the or each supply opening in an upper region at the front of the interspace.

An embodiment of the prior art and embodiments of the present invention will now be described with reference to the accompanying drawings, in which:

Fig. 1 is a perspective view of a natural air convection cooled rack for vertically disposed printed boards according to the prior art.

Fig. 2 is a perspective view of a natural air convection cooled rack for vertically disposed printed boards according to the present invention.

Fig. 3 through Fig. 7 are perspective views of ventilation equipment of different examples of the rack according to the present invention, respectively.

Fig. 8 is a graphical view which represents temperature rise in the rack of the prior art and the rack of the present invention.

Fig. 9 is a perspective view of racks of the prior art and the present invention, which racks were used in the experiment. The rack of prior art in Fig. 9 is different from that of Fig. 1.

With reference to Fig. 1, an example of a natural air convection cooled rack for vertically disposed printed boards according to the prior art is illustrated. Three printed boards cases 1 are shown stacked vertically. Each of these cases 1 houses a number of vertically disposed printed boards 3. Draught apertures 2 are formed on the upper wall of the case 1 so as to exhaust heated air. A draught aperture 4 is formed on the bottom of the case 1 so as to intake cooling air. A baffle plate 5, which is folded to form a V shape, is provided between the printed boards cases 1, 1 so as to prevent heated air from the draught ports 2 from flowing into the upper case 1 through the draught opening 4 thereof. However, in such a natural air convection cooled rack for vertically disposed printed boards, a part of the heated air exhausted through the draught apertures 2 of the lower printed boards case 1, as represented by an arrow A, flows into the upper printed boards case 1 through the draught aperture 4 thereof, as represented by an arrow A'. Therefore, the draught air temperature of the upper case becomes high and the cooling effect of the printed board case is greatly degraded in the upper case.

In another prior art rack, a flat baffle plate obliquely partitions the space between the cases, i.e. the flat baffle plate is arranged between the front edge of the upper case and the rear edge of the lower case. In such a rack, air from behind the rack is supplied into the case through the lower draught aperture and heated air is exhausted to the front of the rack through the upper draught apertures. In back-to-back arrangement of such racks, since the space between the two back surfaces is narrow and since cables are disposed in this narrow space, the supply of cooling air is not sufficient and thus the desired cooling effect is not obtained.

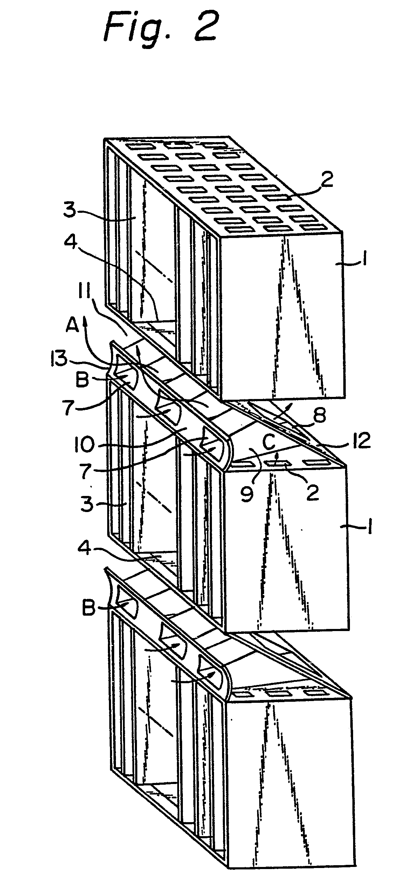

An embodiment of the rack according to the present invention will now be described with reference to Fig. 2. A number of printed boards 3 are vertically interspaced and housed within a box shaped case 1. Draught apertures 2 are formed on the upper surface of the case 1 so as to exhaust heated air out of the case 1. A draught aperture 4 is formed on the lower surface of the case 1 so as to introduce cooling air into the case 1. A baffle plate 12 is obliquely arranged between the cases 1 and 1. A baffle wall 13 is provided in the front under portion of the space between the cases 1 and 1. The baffle wall 13 has supply openings 7 each of which communicates with a supply outlet 8 formed on the baffle plate 12 through a supply passage 9. The front upper portion of the space between the cases 1, is opened so as to serve as an exhaust opening 11 which communicates with the upper draught ports 2 of the lower case 1. A plurality of cases 1 are supported and housed within a rack frame (not shown). If many cases are installed within the rack frame, the interspace between the cases for supplying and exhausting draught air may be formed in every two or three cases instead of every case.

In the rack of the above mentioned construction, air is heated by electronic elements (not shown) mounted on the printed boards 3 in the case 1. The heated air flows through the draught apertures 2 as shown by an arrow C and then is exhausted through the exhaust opening 11 and rises in front of the upper case 1 as shown by an arrow A. Cool air is introduced through the supply openings 7 as shown by an arrow B. The cool air passes through the supply passage 9 and the supply outlet 8 and then flows into the upper printed board case 1 through the lower draught aperture 4 thereof so as to cool off the printed boards 3. Each of the printed boards 3 is cooled by the above mentioned natural convectional air circulation. Since the supply openings 7 are located below the exhaust opening 11, the heated air exhausted through the exhaust opening 11 never flows into the supply openings 7. Sufficiently cool air is introduced through the supply openings 7. Therefore, the cooling effect of the upper cases can be kept within a tolerance limit.

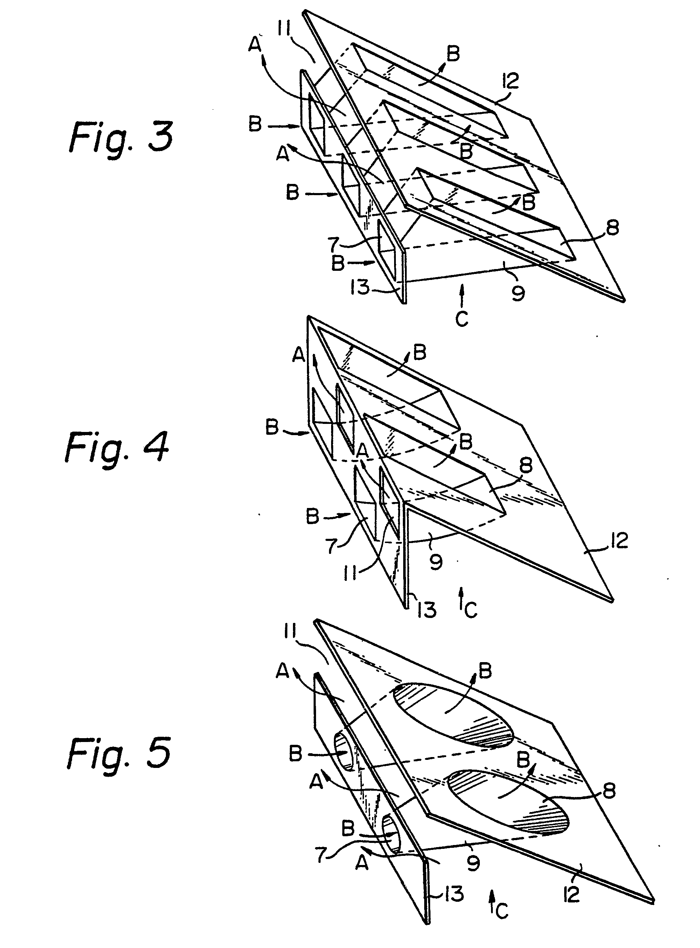

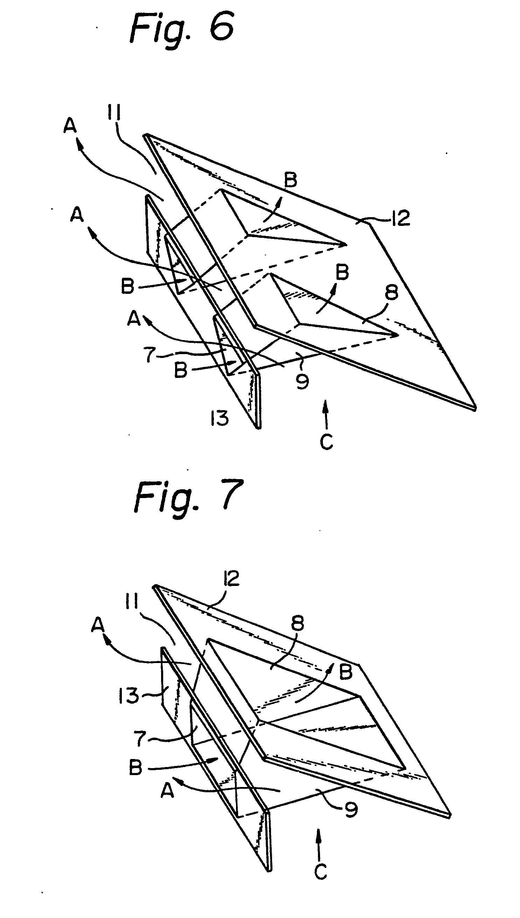

Other examples of natural ventilation equipment of the rack according to the present invention are illustrated in Figs. 3 through 7. In each of the examples, the exhaust opening 11 is located above the supply opening 7 and the heated air from the exhaust opening 11, as shown by the arrow C, flows upward, as shown by the arrow A, so that the heated air is never introduced into the supply opening 7.

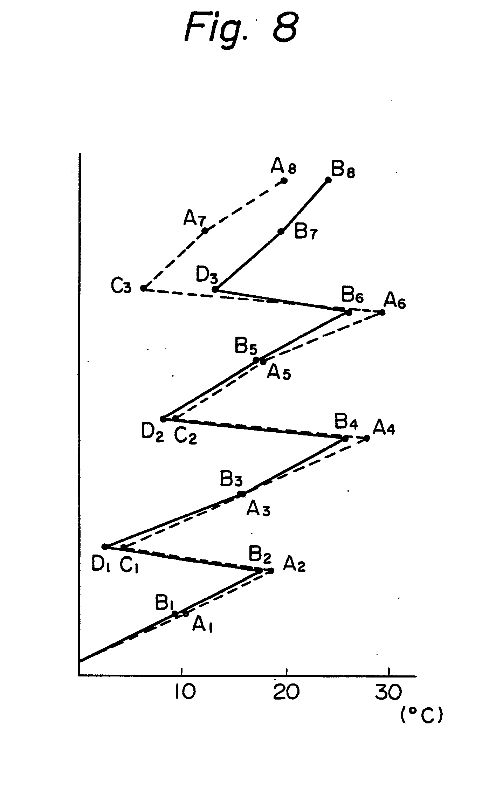

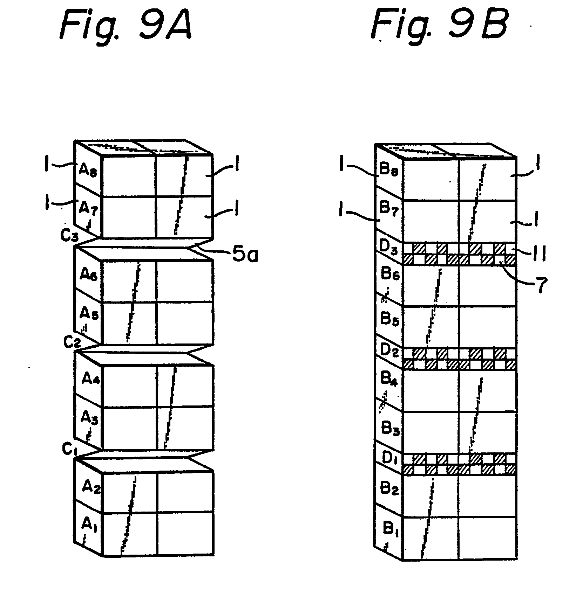

In Fig. 8, an experimental result of the air temperature increase in the rack is graphically illustrated. A solid line represents the case of the rack according to the present invention and a dotted line represents the case of the rack according to the prior art. The rack of the prior art used in the experiment is illustrated in Fig. 9(A). In this rack, a baffle plate 5a is obliquely installed in the interspace between every two printed board cases 1. This rack has a height of 2375 mm, a width of 520 mm and a depth of 225 mm. The interspace between every two cases is 125 mm. Two racks of this kind are arranged in a back-to-back arrangement. Electrical power is supplied to each of the racks, so as to energize the electric or electronic parts on the printed boards which are evenly disposed in each case. In this state, the air temperature is measured at the upper center portion of each of the cases ($A_1$ through $A_8$). Also, the supply air temperature is measured at the back portion ($C_1$, $C_2$, $C_3$) of each baffle plate 5a.

The rack of the present invention used in the experiment is illustrated in Fig. 9(B). Experimental conditions are the same as in the rack of the prior art. Air temperature in each of the printed board cases ($B_1$ through $B_8$) and supply air temperature through the supply opening 7 are measured. The abscissa of the graph of Fig. 8 represents the difference between the measured temperature and the room temperature. The ordinate represents the measuring position. As can be seen from the graph, at the points $A_6$ and $B_6$ each of which represents the maximum temperature of each rack, the rack of the present invention has a temperature of about 3°C lower than does the rack of prior art. Therefore, in the rack of the present invention, the maximum air temperature can be lowered so as to prevent the temperature of the rack from exceeding the thermal tolerance limit.

In the illustrated embodiments of the present invention in the drawings, the front of each printed board case and the side ends of each ventilation equipment are not covered for the clarification of the drawings. However, in the actual use, they are covered by an appropriate front panel and side panels. The front of the ventilation equipment arranged between upper and lower cases is covered by a grille or the like which does not prevent air ventilation.

In the above mentioned embodiments heretofore, all the printed board cases house a number of printed boards. However, electric devices such as power source, control unit and display unit may be housed within some of the cases instead of a part of or all of the printed boards. The present invention includes a rack which comprises cases within which electric devices other than printed boards are housed.

## Claims

1. An electronics rack cooled by natural air convection, comprising at least two cases stacked one above the other so as to define an interspace therebetween, at least one draught aperture in the top of the lower case opening into the interspace, at least one draught aperture in the bottom of the upper case opening into the interspace, and means for channelling air from the or each aperture in the lower case to at least one exhaust opening and for channelling air to the or each aperture in the upper case from at least one supply opening, the supply and exhaust openings being located in different regions of the front of the interspace, characterised in that the air channelling means comprises a baffle (12) partitioning the interspace into upper and lower compartments communicating respectively with the apertures of the upper and lower cases, one of the compartments being located so as to communicate directly with the front of the interspace, and at least one passage (9) extending from an opening (8) in the baffle (12) through the said one compartment so as to connect the other compartment to the front of the interspace, the baffle and said at least one passage being arranged such that the upper compartment communicates only with one or more supply openings (7) located in a lower region at the front of the interspace and the lower compartment communicates only with one or more exhaust openings (11) located above the or each supply opening in an upper region at the front of the interspace.

2. An electronics rack according to claim 1, characterised in that the baffle (12) comprises a plate inclined downwards from the front edge of the bottom of the upper case to the rear edge of the top of the bottom case, said at least one passage (9) extending from the opening (8) in the baffle plate to a supply opening (7) located adjacent the front edge of the top of the lower case.

3. An electronics rack according to claim 2, characterised in that the or each supply opening (7) is provided in a baffle wall (13) extending upwards from the front edge of the top of the lower case.

4. An electronics rack according to any preceding claim, characterised in that three or more cases are provided stacked one above the other and an interspace is formed between every pair of adjacent cases.

5. An electronics rack according to any one of claims 1 to 3, characterised in that three or more cases are provided stacked one above the other and an interspace is not formed between every pair of adjacent cases.

## Patentansprüche

1. Durch natürliche Luftkonvektion gekühltes elektronisches Gestell, mit wenigstens zwei Kästen, welche so übereinander angeordnet sind, daß sie zwischeneinander einen Zwischenraum begrenzen, wenigstens einer sich in den Zwischenraum öffnenden Luftströmungsöffnung in der Oberseite des unteren Kastens, wenigstens einer sich in den Zwischenraum öffnenden Luftströmungsöffnung in der Unterseite des oberen Kastens, und wenigstens einer Einrichtung zur Kanalisierung der Luft von der oder jeder Öffnung in dem unteren Kasten zu wenigstens einer Auslaßöffnung und zur Kanalisierung von Luft von wenigstens einer Einlaßöffnung zu der oder jeder Öffnung in dem oberen Kasten, wobei die Einlaßöffnungen und die Auslaßöffnungen in verschiedenen Bereichen der Vorderseite des Zwischenraums angeordnet sind, dadurch gekennzeichnet, daß die Luftkanalisierungseinrichtung eine Trenneinrichtung (12) umfaßt, welche den Zwischenraum in obere und untere Abteile unterteilt, welche mit den Öffnungen des oberen bzw. des unteren Kastens kommunizieren, wobei eines der Abteile so angeordnet ist, daß es direkt mit der Vorderseite des Zwischenraums kommuniziert und wenigstens eine Passage (9) sich von einer Öffnung (8) durch das genannte eine Abteil in die Trenneinrichtung (12) erstreckt, um so das andere Abteil mit der Vorderseite des Zwischenraums zu verbinden, wobei die Trenneinrichtung und die genannte wenigstens eine Passage so angeordnet sind, daß das obere Abteil nur mit einer oder mehreren Zuleitungsöffnungen (7) in einem unteren Bereich an der Vorderseite des Zwischenraums und das untere Abteil nur mit einer oder mehreren Auslaßöffnungen (11) oberhalb der oder jeder Einlaßöffnung in einem oberen Bereich an der Vorderseite des Zwischenraums kommunizieren.

2. Elektronisches Gestell nach Anspruch 1, dadurch gekennzeichnet, daß die Trenneinrichtung (12) eine von der vorderen Kante der Unterseite des oberen Kastens zu der hinteren Kante der Oberseite des unteren Kastens nach unten geneigte Platte umfaßt, daß die genannte wenigstens eine Passage (9) sich von der Öffnung (8) in die Trenneinrichtung zu einer Einlaßöffnung (7) erstreckt, welche neben der vorderen Kante der Oberseite des unteren Kastens angeordnet ist.

3. Elektronisches Gestell nach Anspruch 2, dadurch gekennzeichnet, daß die oder jede Einlaßöffnung (7) in einer Trennwand (13) vorgesehen ist, welche sich von der vorderen Kante der Oberseite des unteren Kastens nach oben erstreckt.

4. Elektronisches Gestell nach einem der vorhergehenden Ansprüche dadurch gekennzeichnet, daß drei oder mehr Kästen übereinander angeordnet vorgesehen sind und daß zwischen je zwei benachbarten Kästen ein Zwischenraum gebildet ist.

5. Elektronisches Gestell nach einem der Ansprüche 1 bis 3, dadurch gekennzeichnet, daß drei oder mehr Kästen übereinander angeordnet sind und nicht zwischen jeweils zwei benachbarten Kästen ein Zwischenraum vorgesehen ist.

**Revendications**

1. Bâti d'empilage électronique refroidi par convection d'air naturelle, comprenant au moins deux boîtiers empilés l'un au-dessus de l'autre de façon à définier entre eux un espace intermédiaire, au moins une ouverture d'appel d'air située sur le dessus du boîtier inférieur et ouvrant dans l'espace intermédiaire, au moins une ouverture d'appel d'air située sur le dessous du boîtier supérieur et ouvrant dans l'espace intermédiaire, et un moyen permettant de canaliser l'air venant de l'ouverture ou de chaque ouverture du boîtier inférieur jusqu'à au moins une ouverture d'évacuation et de canaliser l'air arrivant à l'ouverture ou à chaque ouverture du boîtier supérieur en provenance d'au moins une ouverture d'alimentation, les ouvertures d'alimentation et d'évacuation étant placées dans des régions différentes du devant de l'espace intermédiaire, caractérisé en ce que le moyen de canalisation d'air comprend un écran (12) qui sépare l'espace intermédiaire en compartiments supérieur et inférieur communiquant respectivement avec les ouvertures des boîtiers supérieur et inférieur, un premier des compartiments étant placé de façon à communiquer directement avec le devant de l'espace intermédiaire, et au moins un passage (9) s'étendant d'une ouverture (8) ménagée dans l'écran (12) par l'intermédiaire dudit premier compartiment de façon à relier l'autre compartiment au devant de l'espace intermédiaire, l'écran et ledit passage étant disposés de façon que le compartiment supérieur ne communique qu'avec une ou plusieurs ouvertures d'alimentation (7) placées dans une région inférieure sur le devant de l'espace intermédiaire et que le compartiment inférieur ne communique qu'avec une ou plusieurs ouvertures d'évacuation (11) placées au-dessus de l'ouverture ou de chaque ouverture d'alimentation dans une région supérieure du devant de l'espace intermédiaire.

2. Bâti d'empilage électronique selon la revendication 1, caractérisé en ce que l'écran (12) comprend une plaque inclinée vers le bas allant du bord antérieur du dessous du boîtier supérieur jusqu'au bord postérieur de dessus du boîtier inférieur, ledit passage (9) s'étendant de l'ouverture (8) ménagée dans la plaque d'écran jusqu'à une ouverture d'alimentation (7) disposée au voisinage du bord antérieur du dessus du boîtier inférieur.

3. Bâti d'empilage électronique selon la revendication 2, caractérisé en ce que l'ouverture ou chaque ouverture d'alimentation (7) est ménagée dans une paroi d'écran (13) se prolongeant vers le haut depuis le bord antérieur du dessus du boîtier inférieur.

4. Bâti d'empilage électronique selon l'une quelconque des revendications précédentes, caractérisé en ce que trois boîtiers ou plus sont empilés l'un au-dessus de l'autre et un espace intermédiaire est formé entre chaque paire de boîtiers adjacents.

5. Bâti d'empilage électronique selon l'une quelconque des revendications 1 à 3, caractérisé en ce que trois boîtiers ou plus sont empilés l'un au-dessus de l'autre et un espace intermédiaire n'est pas formé entre chaque paire de boîtiers adjacents.

# Fig. 1

# Fig. 2

**0 020 084**

*Fig. 3*

*Fig. 4*

*Fig. 5*

3

## Fig. 6

## Fig. 7

## Fig. 8

# Fig. 9A

# Fig. 9B